# EUROPEAN PATENT APPLICATION

(11) **EP 4 764 875 A1**
(43) Date of publication of application: **24.06.2026**
(21) Application number: 24221216.5
(22) Date of filing: 18.12.2024
(51) Int. Cl.: G06F 13/16, G06F 5/06, G06F 13/40, G06F 13/42, G06F 1/12, G06F 1/3237, G06F 1/324, H04L 7/00

(54) **SYSTEM AND METHOD FOR DATA READING IN A MULTI-CLOCK ENVIRONMENT**

(71) Applicant: EM Microelectronic-Marin SA, 2074 Marin (CH)
(72) Inventor: Sima, Ovidiu, 8055 Zurich (CH)
(74) Representative: ICB SA

(57) **Abstract**

An aspect of the invention describes a data reading system comprising two clock sources (CS1 and CS2), a configuration/access interface (C/A-I), and various logic and register modules. The system includes a configuration/access logic module (C/A-L) that receives signals from CS1 and interfaces with the data logic module (DL). The data register module (DR) stores data and provides it to a data output register module (DOR), which generates a data output signal. The system features a read window generator (RWG) and a read manager (RM) to manage reading operations. The system operates in an idle or reading state, controlling data flow based on the state of the configuration/access interface.

## Description

### Field of the invention

The invention pertains to digital systems, specifically methods for reading data from peripherals in environments where components operate on different clock sources. It applies to systems that include a configuration/access interface and a data logic unit, often found in digital and embedded systems.

### Background of the invention

In conventional digital systems, different components commonly operate with separate clock signals. For example, a configuration/access interface might operate with a clock signal distinct from the one used by a data logic unit.

Ensuring consistent data reading across the separate clock domains requires precise synchronization to avoid errors. Traditional synchronization methods often introduce significant latency, impacting overall system performance by delaying data availability.

Two primary techniques are typically used in current digital systems to manage data consistency between clock domains.

Dual-Read Comparison Method: In this approach, the configuration/access interface reads the data register (DR) twice and compares the two values. If the values match, the read data is considered correct. If not, the process must be repeated. Although effective for ensuring data stability, this method is time-consuming and can add considerable delay, particularly in high-frequency applications.

Ready Signal Synchronization Method: In this second technique, the configuration/access interface includes a ready signal input, which is managed by the data logic (DL). When the configuration/access interface initiates a read operation by setting the read signal to '1', the data logic sets the ready signal to '1' only once the data register is stable and ready for reading. The configuration/access interface then waits for this ready signal before proceeding with the data read. While this method can improve data stability, it may consume significant time and power, especially in cases where one clock operates at a very high frequency and the other at a very low frequency.

These existing solutions, while functional, create trade-offs between timing precision, power efficiency, and latency, making them less suitable for applications that require rapid, low-latency data access.

### Summary of the invention

According to a first aspect of the invention, it is disclosed that a data reading system includes:
- a first clock source and a second clock source, the first clock source being configured to provide a first clock source signal and the second clock source being configured to provide a second clock source signal;
- a configuration/access interface; The sampling edge for the configuration/access interface is rising edge or falling edge of the first clock source;
- a configuration/access logic module configured to receive the first clock source signal and connected to the configuration/access interface; The sampling edge for the configuration/access logic module is rising edge or falling edge of the first clock source;
- a data logic module configured to receive the second clock source signal and connected the configuration/access logic module. The sampling edge for the data logic module is rising edge or falling edge of the second clock source;
- a data register module configured to store a data, to receive the second clock source signal, to generate a data signal which represents the data, and to interact with the data logic module. The sampling edge for the data register module is rising edge or falling edge of the second clock source.

The system further comprises:
- a data output register module configured to store a data, said data output, to receive the data signal, and to generate a data output signal which represents the data output;
- a read window generator module which is connected to the configuration/access logic module and configured to generate a sample data signal;
- a read manager module which is configured to receive the second clock source and which is connected to the read window generator module;
- a read clock controller module which is configured to receive the second clock source and which is connected to the data output register module.

The configuration/access interface presents a state corresponding to an idle state or a reading state.

In the disclosed system:
- the configuration/access logic module is configured to generate a read signal (read) on the sampling edge of first clock signal which represents the state of the configuration/access interface;
- the configuration/access interface logic module is configured to receive the data output signal on the next sampling edge of first clock signal after the read signal (read) has been set to '1';
- the data output register module being further configured to store the data received from the data signal as its data output when the read signal corresponds to the idle state of the configuration/access interface.

A clock source may be understood as a device that generates a periodic signal used to synchronize the operations of various components in an electronic system.

According to another object of the invention, it is disclosed that a method for reading system, comprising the steps:
- providing a first clock signal from a first clock source and a second clock signal from a second clock source;
- receiving, by a configuration/access logic module, the first clock signal via a configuration/access interface;
- receiving, by a data logic module, the second clock signal and interacting with the configuration/access logic module;
- storing data in a data register module, receiving the second clock signal, and generating a data signal representing the data.

The method further comprises:
- storing data in a data output register module, receiving the data signal, and generating a data output signal representing the stored data;
- generating a read window using a read window generator module, connected to the configuration/access logic module and configured to generate a sample data signal;
- managing the reading of data using a read manager module, receiving the second clock signal and interacting with the read window generator module, before the next sampling edge of first clock signal;
- controlling the read clock using a read clock controller module, receiving the second clock signal and interacting with the data output register module;
- determining a state of the configuration/access interface, the state corresponding to an idle state or a reading state;
- generating a read signal representing the state of the configuration/access interface via the configuration/access logic module;
- receiving the data output signal by the configuration/access logic module;
- storing the data received from the data signal as the data output in the data output register module when the read signal corresponds to the idle state of the configuration/access interface.

Preferably, the read window generator module is activated when the read signal is set to '1' by the configuration/access interface and deactivated when the read signals is set to '0' by the configuration/access interface.

Preferably, the sample data signal is set to '1' after the read signal has been set to '1', by the configuration/access interface, but before the next sampling edge of the first clock source, and set back to '0' when the read signal is set to '0' by the configuration/access interface.

Preferably, the data output register module is a copy of the data register module DR while the configuration/access interface is in the idle state.

Preferably, a change in the data register module, that is ongoing or has started when the sample data signal is set to '1' is transferred to the data output register module.

### Brief description of the drawings

The present invention will be described subsequently in more detail with reference to the attached drawing, given by way of examples, but in no way limited thereto, in which:
- Figure 1 is a schematic diagram illustrating a system architecture;
- Figure 2 is a flowchart depicting the operational stages of the data read process;
- Figure 3 is an example timing diagram illustrating the relationships between signals.

### Detailed description of the invention

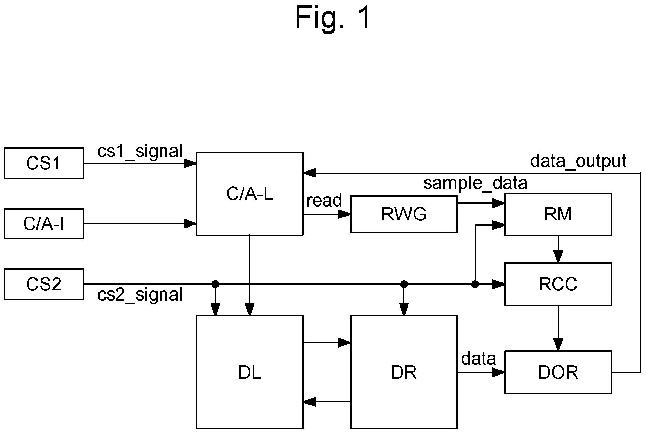

Figure 1 is a block diagram which illustrates a functional overview of a data reading system in a digital environment.

The data reading system includes:
- a first clock source CS1 and a second clock source CS2;
- a configuration/access interface C/A-I;
- a configuration/access logic module C/A-L connected to the first clock source CS1 and to the configuration/access interface C/A-I;
- a data logic module DL connected to the second clock source CS2 and to the configuration/access logic module C-A/L;
- a data register module DR connected to the second clock source CS2 and which interacts with the data logic module DL;
- a data output register module DOR which is connected to the data register module DR, and to the configuration/access interface logic module C/A-L;
- a read window generator module RWG which is connected to the configuration/access logic module C/A-L;
- a read manager module RM which is connected to the second clock source CS2 and to the read window generator module RWG;
- a read clock controller module RCC which is connected to the read manager module RM and to the data output register module DOR.

These two clock sources CS1, CS2 are configured to provide clock signals, a first signal cs1_signal and a second signal cs2_signal, necessary for the system's operation.

The configuration/access interface C/A-I is configured to allow users or systems to configure or access the system's data. A "Configuration/Access Interface" is a hardware or software component in an electronic system which is configured to allow for the configuration and access to data or parameters of another component, such as a peripheral or a data register. It serves as a point of interaction for users or other systems to read or modify the data, parameters, or internal states of the controlled device. In the context of embedded systems or microcontrollers, this interface can, for example, be used to configure registers, read sensor data, or control peripherals by communicating with specific circuits or modules through control signals or data buses.

The configuration/access logic is a set of circuits or software modules in an electronic system that manages the configuration and data access operations of a system or component. This type of logic is responsible for handling communications between the configuration/access interface and other parts of the system, such as data registers, peripherals, or processing units.

The configuration/access logic is a set of circuits or software modules in an electronic system that manages the configuration and data access operations of a system or component. This type of logic is responsible for handling communications between the configuration/access interface C/A-I and other parts of the system, such as data registers, peripherals, or processing units.

The data register module DR is updated based on the algorithm in the data logic DL. In case of a Timer the data register is the Timer counter value.

The data output register module DOR is a copy of the data register module DR while the configuration/access interface C/A-I is in idle state. The data output register module DOR and the data output signal are the same. The read window generator module RWG is configured to receive a read signal generated by the configuration/access logic module C/A-L, on the sampling edge of first clock signal.

The read window generator module RWG is also configured to generate a time window allowing the read manager module RM to manage data access.

The read window generator module RWG will enable the read manager RM for a short time before the next edge of the first clock source CS1. This is done by setting the Sample_Data signal to '1'. The Sample_Data will go back to '0' when the read signal is going back to '0'.

The read clock controller module RCC just enable or disable the second clock source CS2 for data output register module DOR based on the input from read manager RM. The read window generator RWG initiates the read manager RM a predetermined time before the next sampling clock edge of the *cs1_signal* signal upon the read signal read. The read manager RM, which includes a read clock controller RCC, is configured for ensuring the data output register DOR is accurately updated before being sampled by the configuration/access interface C/A-I. The read clock controller RCC manages the timing of the update to prevent changes to the data output register DOR while the data register module DR is being updated. If the data register module DR is being updated the read manager RM and the read clock controller RCC will wait for the update to finish and then copy this value to the data output register DOR. Once update is done, the second clock source CS2 will be disabled for the data output register DOR and the data output register DOR will not change anymore as long as read signal is at '1'.

Overall, the diagram visualizes a method and system that ensure data consistency and synchronization across various clock domains and operational stages of data reading in a peripheral device.

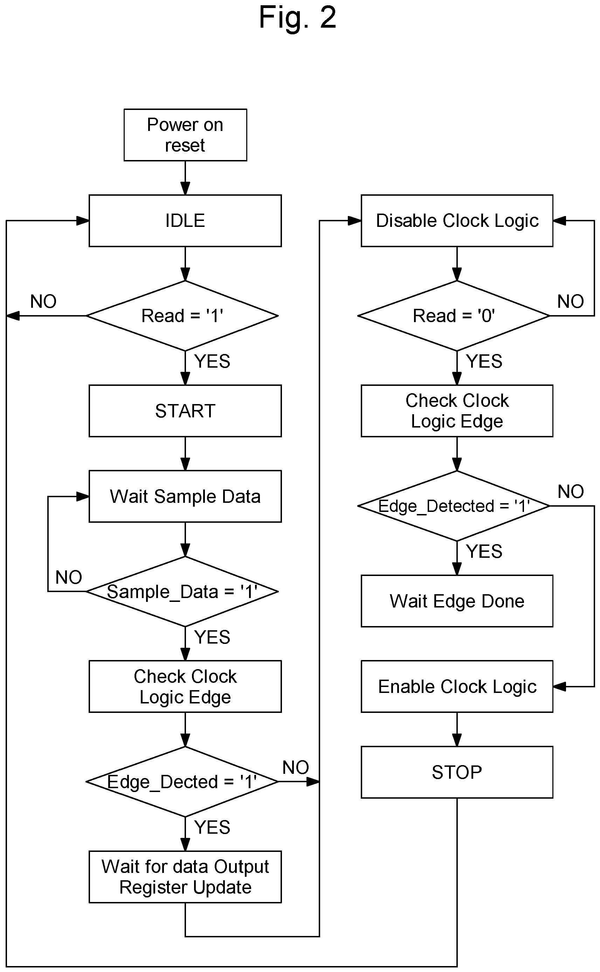

Figure 2 is a flowchart which begins with a box labeled "Power on reset" which leads into a state box labeled "IDLE".

From the IDLE state, the flowchart splits into two paths based on the condition "Read = '1'". If the condition is "NO" it loops back to the IDLE state. If "YES" the flow progresses to a state labeled "START".

Following the "START" state, the flowchart proceeds to a state "Wait Sample Data". The read window generator module RWG will enable the read manager RM for a short time before the next edge of the first clock source CS1. This is done by setting the Sample_Data signal to '1'. Then, if a condition "Sample_Data = '1'"is "NO" it loops back to the state "Wait Sample Data" and when "YES" it moves to a state labeled "Check Clock Logic Edge". The "Check Clock Logic Edge" state will detect if there is an active sampling edge for the second clock source CS2.

Following the "Check Clock Logic Edge" state, the flowchart splits into two paths based on the condition "Edge_Detected = '1". If the condition is "NO" the flow progress to a state "Disable Clock Logic". The "Disable Clock Logic" state will disable the second clock source CS2 for the data output register DOR. If "YES" the flow progresses to a state "Wait for Data Output Register Update". The "Wait for Data Output Register Update" state will wait while the sampling edge for the second clock source CS2 is active and the data from the data output register DOR is being update.

Following the "Wait for Data Output Register Update" state, the flowchart proceeds to the state "Disable Clock Logic".

During the "Disable Clock Logic" state, the data register module DR will continue to change. In case of a Timer the data register will continue to increment. But the data output register DOR will not change anymore as long as read signal is at '1', because the second clock source CS2 will be disabled for the data output register DOR.

From the "Disable Clock Logic" state, the flowchart splits into two paths based on the condition "Read = '0'"which appears when the read signal read is equal to 0. If the condition is "NO" it loops back to the "Disable Clock Logic state". If "YES" the flow progresses to a state labeled "Check Clock Logic Edge".

From the "Check Clock Logic Edge" state, the flowchart splits into two paths based on the condition "Edge_Detected = '1'". If "YES" the flow progresses to a state box labeled "Wait Edge Done". The "Wait Edge Done" state will wait while the sampling edge for the second clock source CS2 is active. If "NO", the flowchart further progress to a stated box labeled "Enable Clock Logic" The "Enable Clock Logic" state will enable the second clock source CS2 for the data output register DOR.

Following the "Wait Edge Done" state, the flowchart proceeds to the state "Enable Clock Logic".

Following the "Enable Clock Logic" state, the flowchart proceeds to a state box labeled "STOP".

Following the STOP state, the flowchart proceeds to the IDLE state.

Each of the boxes and decision points represents operations or assessments to be performed according to the steps described in the invention for managing the synchronization between the reading of data from a register and ensuring its integrity during the reading process across potentially different clock domains.

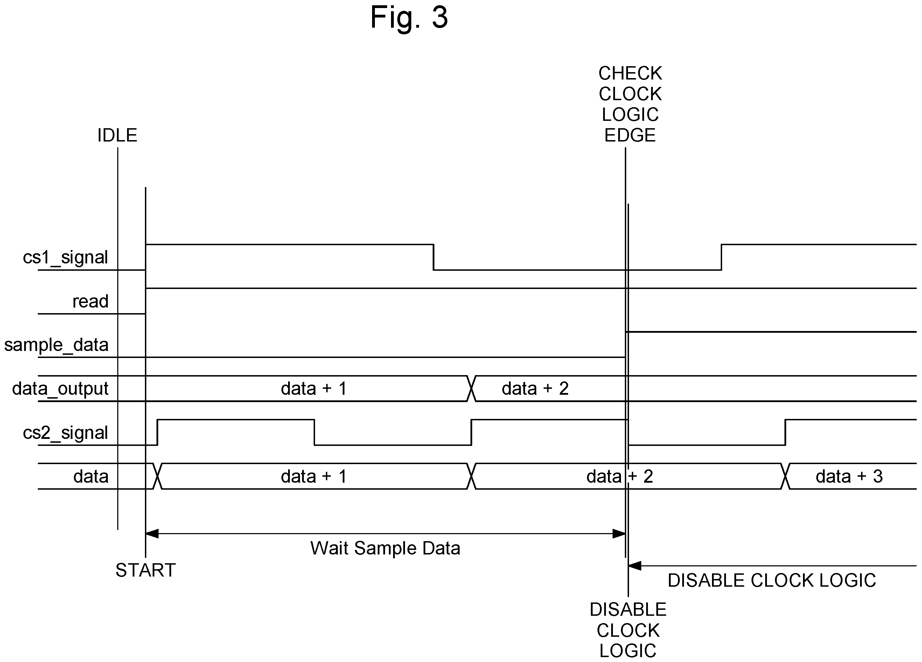

Figure 3 is a timing diagram that relates to a system and method for reading data from a peripheral. The figure visually represents the timing and interaction of different signals to demonstrate how the read process is managed in synchronization with various clock edges and data updates.

At the top of the figure, the cs1_signal signal is represented, which is the clock signal for the configuration/access interface C/A-I. It can be assumed that the process starts with the IDLE status.

At the bottom of the figure, the cs2_signal signal is represented, which is the clock signal for the data logic module DL.

The signal data generated by the data logic module DL is represented under the cs2_signal signal. Data transitions, marked as data, data+1, data+2, data+3 signify changes or increments in the data state within the Data Register as time progresses.

The read signal below cs1_signal signal indicates when a read operation is initiated. As soon as the read signal value equals 1, the process progress with the START status and then progress with the "WAIT SAMPLE DATA" status.

The sample_data line below the read signal demonstrates the point at which the data is sampled.

Below the sample_data line, we find the data_output signal line, which appears to show a 'data + 2' value, indicating the instance when the data output register DOR is updated or holds a stable value.

The figure provides a clear visual representation of the timing coordination required between the different components and signals to ensure accurate and stable data reads from the peripheral.

## Claims

1. A data reading system includes:
- a first clock source (CS1) and a second clock source (CS2), the first clock source being configured to provide a first clock source signal (cs1_signal) and the second clock source being configured to provide a second clock source signal (cs2_signal);
- a configuration/access interface (C/A-I);
- a configuration/access logic module (C/A-L) configured to receive the first clock source signal (cs1_signal) and connected to the configuration/access interface (C/A-I);
- a data logic module (DL) configured to receive the second clock source signal (cs2_signal) and connected the configuration/access logic module (C-A/L);
- a data register module (DR) configured to store a data, to receive the second clock source signal (cs2_signal), to generate a data signal (data) which represents the data, and to interact with the data logic module (DL);
**characterized in that** the system further comprises:
- a data output register module (DOR) configured to store a data, said data output, to receive the data signal (data), and to generate a data output signal (data_output) which represents the data output;
- a read window generator module (RWG) which is connected to the configuration/access logic module (C/A-L) and configured to generate a sample data signal (sample_data);
- a read manager module (RM) which is configured to receive the second clock source (CS2) and which is connected to the read window generator module (RWG);
- a read clock controller module (RCC) which is configured to receive the second clock source (CS2) and which is connected to the data output register module (DOR),
wherein
- the configuration/access interface (C/A-I) presents a state corresponding to an idle state or a reading state;
- the configuration/access logic module (C/A-L) is configured to generate a read signal (read) on the sampling edge of first clock signal (cs1_signal) which represents the state of the configuration/access interface;
- the configuration/access interface logic module (C/A-L) is configured to receive the data output signal (data_output) on the next sampling edge of first clock signal (cs1_signal) after the read signal (read) has been set to '1';
- the data output register module (DOR) being further configured to store the data received from the data signal (data) as its data output when the read signal corresponds to the idle state of the configuration/access interface (C/A-I).

2. A method for reading data, comprising the steps of:
- providing a first clock signal (cs1_signal) from a first clock source (CS1) and a second clock signal (cs2_signal) from a second clock source (CS2);
- receiving, by a configuration/access logic module (C/A-L), the first clock signal (cs1_signal) via a configuration/access interface (C/A-I);
- receiving, by a data logic module (DL), the second clock signal (cs2_signal) and interacting with the configuration/access logic module (C/A-L);
- storing data in a data register module (DR), receiving the second clock signal (cs2_signal), and generating a data signal (data) representing the data;
**characterized in that** the method further comprises:
- storing data in a data output register module (DOR), receiving the data signal (data), and generating a data output signal (data_output) representing the stored data;
- generating a read window using a read window generator module (RWG), connected to the configuration/access logic module (C/A-L) and configured to generate a sample data signal (sample_data);
- managing the reading of data using a read manager module (RM), receiving the second clock signal (CS2) and interacting with the read window generator module (RWG), before the next sampling edge of first clock signal (cs1_signal);
- controlling the read clock using a read clock controller module (RCC), receiving the second clock signal (CS2) and interacting with the data output register module (DOR);
- determining a state of the configuration/access interface (C/A-I), the state corresponding to an idle state or a reading state;
- generating a read signal (read) representing the state of the configuration/access interface (C/A-I) via the configuration/access logic module (C/A-L);
- receiving the data output signal (data_output) by the configuration/access logic module (C/A-L);
- storing the data received from the data signal (data) as the data output in the data output register module (DOR) when the read signal corresponds to the idle state of the configuration/access interface (C/A-I).

3. The method for reading data according to claim 2, wherein the read window generator module (RWG) is activated when the read signal is set to '1' by the configuration/access interface (C/A-I) and deactivated when the read signals is set to '0' by the configuration/access interface (C/A-I).

4. The method for reading data according to claim 2, wherein the sample data signal (sample_data) is set to '1' after the read signal has been set to '1', by the configuration/access interface (C/A-I), but before the next sampling edge of the first clock source (CS1), and set back to '0' when the read signal is set to '0' by the configuration/access interface (C/A-I).

5. The method for reading data according to claim 2, wherein the data output register module (DOR) is a copy of the data register module DR while the configuration/access interface (C/A-I) is in the idle state.

6. The method for reading data according to any one of the preceding claims, wherein a change in the data register module (DR), that is ongoing or has started when the sample data signal (sample_data) is set to '1' is transferred to the data output register module (DOR).
